(19) **Europäisches Patentamt / European Patent Office / Office européen des brevets**

(11) **EP 1 921 633 A1**

(12) # EUROPEAN PATENT APPLICATION
published in accordance with Art. 153(4) EPC

(43) Date of publication:
**14.05.2008 Bulletin 2008/20**

(51) Int Cl.:
*H01B 1/08* (2006.01)  *H01L 51/50* (2006.01)
*H05B 33/28* (2006.01)

(21) Application number: **06796440.3**

(22) Date of filing: **15.08.2006**

(86) International application number:
**PCT/JP2006/316050**

(87) International publication number:
**WO 2007/029457 (15.03.2007 Gazette 2007/11)**

(84) Designated Contracting States:
**DE FR GB**

(30) Priority: **02.09.2005 JP 2005255166**

(71) Applicant: **Idemitsu Kosan Co., Ltd.**
**Chiyoda-ku**
**Tokyo 100-8321 (JP)**

(72) Inventors:
• **TOMAI, Shigekazu**
**Sodegaura-shi, Chiba 2990293 (JP)**

• **UMENO, Satoshi**
**Sodegaura-shi, Chiba 2990293 (JP)**

(74) Representative: **Gille Hrabal Struck Neidlein Prop Roos**
**Patentanwälte**
**Brucknerstrasse 20**
**40593 Düsseldorf (DE)**

(54) **CONDUCTIVE COMPOSITION FILM, ELECTRON INJECTION ELECTRODE, AND ORGANIC ELECTROLUMINESCENCE ELEMENT**

(57) A conductive composition film including the following elements A and B, and an oxygen atom:
A: one element selected from In, Sn, and Zn; and
B: one or more elements selected from In, Sn, Zn, V, W, Ni, Pd, Pt, Cu, Ag and Au and different from element A; the total $(x+y)$ of the amount $(x)$ of element A and the amount $(y)$ of element B in the film being larger than 41 at% and smaller than 80 at%; and the amount of the oxygen atom in the film being $[100-(x+y)]$ at%.

FIG. 1

EP 1 921 633 A1

**Description**

TECHNICAL FIELD

The invention relates to a conductive composition film, an electron-injecting electrode, and an organic electroluminescent device.

BACKGROUND

An organic electroluminescent device (hereinafter "electroluminescent" is often referred to as "EL") is a perfectly solid, self-emitting device. Due to its excellent properties such as wide viewing angle and easy handling, displays utilizing an EL device are being briskly developed.
Displays utilizing an EL device are divided into a bottom-emission structure and top-emission structure. When a thin film transistor (TFT) is formed on a substrate in order to drive pixels formed of an EL device, the top-emission structure enables a high aperture ratio in the light-emitting part thereof since light is outcoupled from the side opposite to the substrate on which the TFT is formed, and hence the light is not shielded by the TFT.
For efficient outcoupling of emission from an EL device, the electrode on the light outcoupling side of a top-emission type display is required to have not only low resistance but also high transparency. As examples of a material having such properties, an Mg-Ag alloy is disclosed as a material for the cathode of an organic EL device (see Patent Document 1, for example).
However, an Mg-Ag alloy is opaque, and reflects light generated in an emitting layer. Therefore, the Mg-Ag alloy is required to be used in the form of an extremely thin film (e.g. 10 nm or less) for light outcoupling.
The above problem may be solved by forming a cathode from a transparent conductive oxide such as ITO in contact with an organic layer. However, in such a device, the driving voltage of the device may become high due to a large difference in work function between the organic layer including an emitting layer and the transparent conductive oxide such as ITO.
Patent Document 1: JP-A-2001-043980
The invention has been made in view of the above problem, and an object thereof is to provide a conductive composition film which is transparent and has a small work function.

SUMMARY OF THE INVENTION

The inventors made extensive studies to solve the problem, and have found that a composition film containing In, Zn or Sn, and an oxygen atom, and satisfying a predetermined element ratio, has a high degree of transparency and a small work function. The invention has been made based on this finding.
According to the invention, the following conductive composition film, electron-injecting electrode, and organic EL device are provided.

1. A conductive composition film comprising the following elements A and B, and an oxygen atom:

A: one element selected from In, Sn, and Zn; and
B: one or more elements selected from In, Sn, Zn, V, W, Ni, Pd, Pt, Cu, Ag and Au and different from element A;
the total $(x+y)$ of the amount $(x)$ of element A and the amount $(y)$ of element B in the film being larger than 41 at% and smaller than 80 at%; and
the amount of the oxygen atom in the film being $[100-(x+y)]$ at%.

2. A conductive composition film comprising at least one metal element selected from In, Sn and Zn, and an oxygen atom;
the amount $(x)$ of the metal element in the film being larger than 41 at% and smaller than 80 at%; and
the amount of the oxygen atom in the film being $(100-x)$ at%.
3. A conductive composition film comprising one metal element selected from In, Sn and Zn, and an oxygen atom;
the amount $(x)$ of the metal element in the film being larger than 41 at% and smaller than 80 at%; and
the amount of the oxygen atom in the film being $(100-x)$ at%.
4. An electron-injecting electrode which comprises the conductive composition film according to any one of 1 to 3.
5. The electron-injecting electrode according to 4, which has a light transmittance in the visible range of 20% or more.
6. An organic EL device comprising an anode, a cathode, and, interposed therebetween, an organic layer including an organic emitting layer;
the cathode being the electron-injecting electrode according to 4 or 5.

7. The organic EL device according to 6, wherein the anode is light reflective and emission is outcoupled from the cathode side.

The conductive composition film of the invention is transparent and has a small work function.

BRIEF DESCRIPTION OF THE DRAWINGS

FIG. 1 is a view showing an organic EL device according to a first embodiment of the invention;
FIG. 2 is a view showing an organic EL device according to a second embodiment of the invention; and
FIG. 3 is a view showing an organic EL device according to a third embodiment of the invention.

BEST MODE FOR CARRYING OUT THE INVENTION

The conductive composition film of the invention is explained below in detail.
The conductive composition film of the invention comprises elements A and B, described later, and an oxygen atom. The total ($x+y$) of the amount ($x$) of element A and the amount ($y$) of element B in the film is larger than 41 at% and smaller than 80 at%.

A is one element selected from In, Sn and Zn. $x$, which specifies the amount (at%) of element A in the composition film, is $0<x\leq70$ at%, preferably $40\leq x\leq60$ at%.
B is one or more elements selected from In, Sn, Zn, V, W, Ni, Pd, Pt, Cu, Ag and Au, and different from element A. $y$, which specifies the amount (at%) of element B in the composition film, is $0<y\leq30$ at%, preferably $5\leq y\leq30$ at%.
The total ($x+y$) of the amount ($x$) of element A and the amount ($y$) of element B in the film is $41<x+y<80$ at%, preferably $50\leq x+y<80$ at%.
The amount of oxygen atom in the film is [100-($x+y$)] at%.
Such a composition film has a small work function and exhibits a high light transmittance.

$x$ and $y$ can be measured by means of a secondary ionization mass spectrometer (SIMS). The inventors believe that the composition film of the invention is formed mainly of a mixture of a simple metal of metal element A and/or metal element B and an oxide containing such a metal element.

Of the composition films of the invention, a composition film containing In as element A and Sn or Zn as element B, or a composition film containing In as element A and containing Sn or Zn, and one selected from V, W, Ni, Pd, Pt, Cu, Ag and Au as element B is preferable.
A conductive composition film which comprises at least one metal element selected from In, Sn and Zn, and an oxygen atom, in which the amount of a metal element ($x$) in the film is larger than 41 at% and smaller than 80 at%, and the amount of the oxygen atom in the film is (100-$x$) at% has a small work function and has a high degree of transparency.

The conductive composition film of the invention can be prepared by a method comprising mixing oxide powders containing desired metal elements in certain amounts, and further mixing particles of a metal or an alloy if necessary, sintering the resulting mixture to produce a target, and sputtering the target.
The conductive composition film of the invention can also be prepared by simultaneously sputtering in a chamber a known oxide target, and a wire or the like of a metal or an alloy which is to be incorporated in the film. That is, the conductive composition film of the invention can be prepared by simultaneous sputtering of a metal and a metal oxide, or by using a sputtering target composed of a metal oxide portion and a metal portion which is disclosed in JP-A-2004-030934.
The conductive composition film of the invention can be formed by a known method such as the chemical deposition method, the sol-gel method and the ion-plating method.

The conductive composition film of the invention has a high light transmittance in the visible region and has a small work function, and is therefore suitable as an electron-injecting electrode for various displays.
The light transmittance in the visible range (380 nm to 780 nm) is preferably 20% or more, particularly preferably 50% or more. The electron-injecting electrode of the invention can have a high light transmittance due to the use of a highly transparent composition.
Here, the light transmittance is a value obtained for a film with a thickness of 10 nm.

Next, as an application example of the electron-injecting electrode of the invention, an example where the electrode of the invention is applied to an organic EL device is explained below.

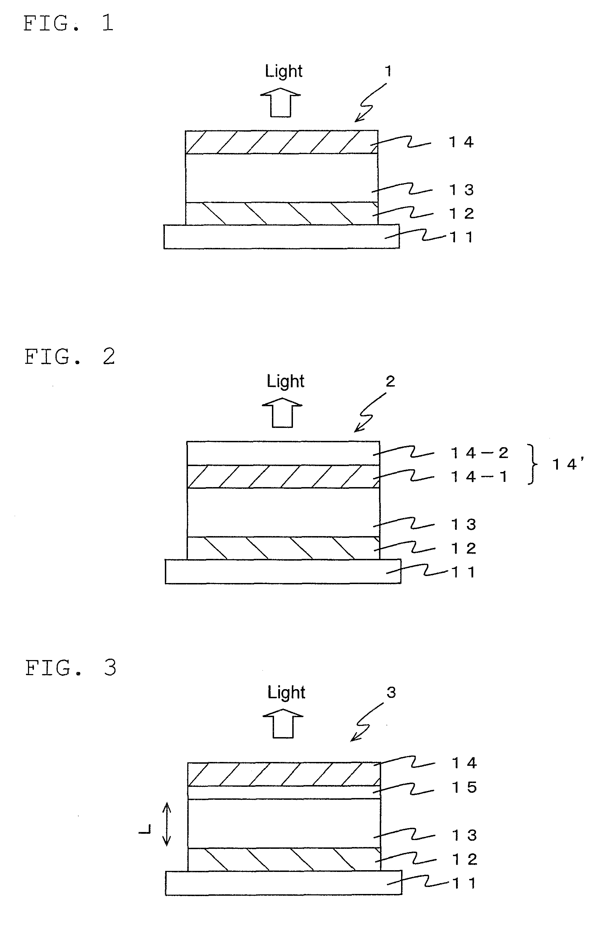

FIG. 1 is a view showing an organic EL device according to a first embodiment of the invention.
The organic EL device 1 has a structure in which an anode 12, an organic layer 13 and a cathode 14 are stacked on a substrate 11 in this order.
In this device, by applying a voltage between the anode 12 and the cathode 14, electrons and holes are injected to the organic layer 13. The electrons and holes are recombined in an organic emitting layer of the organic layer 13, whereby light is emitted. The emission is outcoupled from the device through the cathode 14 which is a transparent electrode.

In this embodiment, the above-mentioned conductive composition film of the invention is used for the cathode 14. By this configuration, a difference in work function between the organic layer 13 and the cathode 14 can be rendered small, thereby lowering the driving voltage of the device. Furthermore, due to high transparency of the cathode 14, light can be efficiently outcoupled from the device.

FIG. 2 is a view showing an organic EL device according to a second embodiment of the invention. The parts corresponding to the above-mentioned first embodiment are indicated by the same numerals, and the explanation thereof is omitted.

The organic EL device 2 is the same as that of the first embodiment, except that the cathode 14 is a stacked electrode 14' composed of an electron-injecting cathode layer 14-1 and a conductive layer 14-2.

In this device, the electron-injecting cathode layer 14-1 formed of the conductive composition film of the invention is provided between the organic layer 13 and the conductive layer 14-2. The conductive composition film of the invention has a work function which is larger than the organic layer 13 and is smaller than the conductive layer 14-2. Therefore, an energy barrier caused by the difference in work function between the organic layer 13 and the conductive layer 14-2 can be reduced.

As for the materials constituting the conductive layer, an explanation will be made later.

FIG. 3 is a view showing an organic EL device according to a third embodiment of the invention. The parts corresponding to the above-mentioned first embodiment are indicated by the same numerals, and the explanation thereof is omitted.

The organic EL device 3 is the same as that of the above-mentioned first embodiment, except that a light-reflective layer 15 is provided between the organic layer 13 and the cathode 14. The light-reflective layer 15 is a layer which reflects part of light generated in the organic layer 13 and transmits part thereof.

The device has an oscillator structure in which a part between the anode 11 and the light-reflective layer 15 serves as an oscillator part. Light generated in the organic layer 13 is repeatedly reflected between the two reflective surfaces (anode 11 and light-reflective layer 15), and light having a wavelength close to the wavelength which satisfies the following equation is intensified. As a result, the light is enhanced as compared with light having other wavelengths, and emitted from the device to the outside.

$$(2L)/\lambda + \Phi/(2\pi) = m$$

wherein L is an optical path length, $\lambda$ is a wavelength of light to intended to be intensified, m is an integer, and $\Phi$ is the phase shift at the light-reflective conductive layer 12 and the light-reflective layer 14.

The optical path length L is the product ($nL_R$) of the refractive index n of a medium through which light passes and the actual length $L_R$.

The organic EL devices shown in FIGs. 1 to 3 are each of top-emission type in which light is emitted through the cathode 14 (14') which is opposite to the substrate 11 to the outside. The organic EL devices may be of bottom-emission type in which light is emitted through the substrate 11 to the outside. Light may also be emitted through both the substrate 11 and the cathode 14 (14') to the outside.

There are no particular restrictions on the material constituting the organic EL device of the invention insofar as the electron-injecting electrode formed of the conductive composition film of the invention is used as the cathode, and known materials can be used. Specific examples will be given below.

(1) Substrate

As for materials for the substrate, glass, a plate or film of a resin such as polyester, amorphous silicon or the like can be used.

(2) Anode

There are no particular restrictions on the material constituting the anode insofar as the material has conductivity and has a work function of 4.8 eV or more. It is preferable to use a metal or a transparent conductive film (conductive oxide film) having a work function of 4.8 eV or more or a mixture of these. The anode is not required to be transparent, and may be coated with a black carbon layer or the like.

Preferable examples of the metal include Au, Pt, Ni, and Pd. Examples of the conductive oxide include In-Zn-O, In-Sn-O, ZnO-Al and Zn-Sn-O. As examples of the multi-layer stack, a multi-layer stack of Au and In-Zn-O, a multi-layer stack of Pt and In-Zn-O, and a multi-layer stack of In-Sn-O and Pt can be given.

It suffices that the anode has the interface with the organic layer having a work function of 4.8 eV or more. Therefore, the anode may be of a two-layer structure, and a conductive film with a work function of 4.8 eV or less may be provided on the side which is not in contact with the organic layer. In this case, a metal such as Al, Ta and W, and an alloy such as an Al alloy and a Ta-W alloy can be used. Also, a doped conductive polymer such as doped polyanilline and doped polyphenylene vinylene, an amorphous semiconductor such as $\alpha$-Si, $\alpha$-SiC and $\alpha$-C, and microcrystals such as $\mu$C-Si and $\mu$C-SiC may also be preferably used. Furthermore, $Cr_2O_3$, $Pr_2O_5$, NiO, $Mn_2O_5$, and $MnO_2$, which are black, semi-conductive oxides, may also be used.

When light is outcoupled from the cathode side, it is preferred that the anode have light reflectivity. Specifically, the light reflectance is preferably 20% or more, more preferably 30% or more. With such a light reflectance, light generated in the emitting layer can be efficiently emitted from the device to the outside. As for the material constituting a light-reflective anode, the above-mentioned metals may preferably be used.

(3) Organic layer

It suffices that the organic layer contains the organic emitting layer. Possible configuration is given below.

(i) Organic emitting layer, only
(ii) Hole-injecting and transporting layer/organic emitting layer
(iii) Hole-injecting and transporting layer/organic emitting layer/electron-injecting and transporting layer

Each of these layers may be a single layer or a stack of two or more layers. An inorganic compound layer may be interposed between layers constituting the organic layer.

The organic emitting layer is preferably composed of a host compound and a dopant. The host compound transports carriers of electrons and/or holes. Preferable examples include known carbazole derivatives and compounds having a condensed heterocyclic skeleton containing a nitrogen atom. The host compound may be a high molecular weight compound. As examples of the high molecular weight compound to be used as the host, monomers, and oligomers such as dimers and trimers which contain carbazole and high molecular weight compounds which contain a carbazole group can be given.

For the hole-injecting and transporting layer, known materials may be used. Examples include poly-N-vinylcarbazole derivatives, polyphenylene vinylene derivatives, polyphenylene, polythiophene, polymethylphenylsilane, polyaniline, triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, carbazole derivatives, styrylanthracene derivatives, fluorenone derivatives, hydrazine derivatives, stilbene derivatives, porphyrin derivatives (e.g. phthalocyanine), aromatic tertiary amine compounds, styrylamine derivatives, butadiene compounds, benzidine derivatives, polystyrene derivatives, triphenylmethane derivatives, tetraphenylbenzene derivatives, and starburst polyamine derivatives.

For electron-injecting and transporting layers, known materials such as oxadiazole derivatives, triazole derivatives, triazine derivatives, nitro-substituted fluorenone derivatives, thopyran dioxide derivatives, diphenylquinone derivatives, fluorenilidene methane derivatives, anthrone derivatives, perylene derivatives, oxine derivatives, and quinoline complex derivatives can be used.

(4) Light-reflective layer

For the light-reflective layer shown in FIG. 3, a layer which can reflect and transmit light generated in the organic emitting layer and can form a light-oscillation part with the above-mentioned anode is used. Specifically, metal films and dielectric multilayer films can be used.

As examples for the metal, metals such as Ag, Mg, Al, Au, Pt, Cu, Cr, Mo, W, Ta, Nb, Li, Mn, Ca, Yb, Ti, Ir, Be, Hf, Eu, Sr, Ba, Cs, Na and K, and alloys thereof can be given. Of these, Al, Ag, Mg, Ce, Na, K, Cs, Li, Au, Pt, Cu, Ca and Ba are preferable.

The dielectric multilayer film is a film which is obtained by stacking a low refractive material layer and a high refractive material layer in such a manner that the optical film thickness (product of the refractive index and the film thickness) of each layer becomes one fourth of the wavelength of light. Specific examples of the low refractive material include SiOx, NaF, LiF, CaFx, AlFx and MgFx. Specific examples of the high refractive material include AlOx, MgOx, NdOx, TiOx, CeOx, PbOx, ZnS, CdS and ZnSe.

(5) Conductive layer

For the multilayer cathode shown in FIG. 2, indium oxide-tin oxide (ITO), indium oxide-zinc oxide (IZO), tin oxide (NESA), gold, silver, platinum, copper, or the like can be used. Of these, IZO is particularly preferable since IZO can form a film at room temperature and peeling rarely occurs due to its high amorphousness.

The above-mentioned layers can be formed by a known method. The film thickness or other factors can be appropriately adjusted within a range known in the art.

EXAMPLES

The invention will be described in more detail with reference to the examples.

Example 1

(1) Formation of conductive composition film

A 4-inch IZO target ($In_2O_3$:ZnO =89.3:10.7 wt%, manufactured by Furuuchi Chemical Corporation) was installed in a sputtering apparatus. 100 In wires ($\Phi$ 1 mm $\times$ 10 mm) were placed on the target. After degassing to $2 \times 10^{-4}$ Pa, sputtering was performed to form a film on glass on the following conditions:

Sputtering pressure: 0.1 Pa
Sputtering gas: argon (100%)
Sputtering output: 0.1 W/cm$^2$
Sputtering time: 30 seconds
The resulting conductive composition film had a thickness of 10 nm and a specific resistance of $2 \times 10^{-3}$ $\Omega \cdot$ cm and had a visible light transmittance of 80%.

The visible light transmittance was measured by means of UV-3100 manufactured by Shimadzu Corporation.
The work function of this film was measured by means of AC-1 (manufactured by Riken Keiki Co., Ltd.), and found to be 4.2 eV. The element ratio of In, Zn and O in this film was measured by means of a secondary ionization mass spectrometer (SIMS). In:Zn:O was 55:10:35.

(2) Preparation of organic EL device

A glass plate measuring 25 mm $\times$ 75 mm $\times$ 1 mm with a 100 nm-thick ITO film thereon (manufactured by Geomatics Corporation) was used as a substrate on which an anode was formed.
The substrate was immersed in isopropyl alcohol, subjected to ultrasonic washing, and then washed with UV light and ozone for 30 minutes by means of an UV irradiator (UV-300, manufactured by Samco International Co., Ltd.).
This substrate was then put in an apparatus which is capable of performing vacuum deposition and sputtering while maintaining vacuum, and secured to a substrate holder provided in this apparatus. The pressure of the vacuum chamber was reduced to $5 \times 10^{-4}$ Pa.
Resistance heat boats in the vacuum deposition apparatus were each filled in advance with 200 mg of Cu-coordinated phthalocyanine (hereinafter abbreviated as "CuPc"), 200 mg of N,N'-bis(3-methylphenyl)-N,N'-diphenyl-(1,1'-biphenyl)-4,4'-diamine (hereinafter abbreviated as "TPD") and 200 mg of 8-quinolinol aluminum complex (aluminum trisoxine, hereinafter abbreviated as "Alq"). A resistance heat filament was filled in advance with an aluminum-lithium alloy (Li content: 2 wt%). These boats and the filament were heated in sequence, whereby each component was deposited.
First, CuPc was deposited as the hole-injecting and transporting layer on the ITO thin film on the glass substrate in a thickness of 25 nm. Then, as a second hole-injecting and transporting layer, TPD was deposited thereon in a thickness of 40 nm. Then, Alq was deposited thereon as an organic emitting layer in a thickness of 60 nm.
Subsequently, the substrate was transferred to a substrate holder in a second vacuum chamber which was connected to the above vacuum deposition apparatus. During this transfer, the degree of vacuum was kept unchanged. The second vacuum chamber had a configuration which allows an oxide conductive film to be formed by DC magnetron sputtering. An IZO target ($In_2O_3$:ZnO=89.3:10.7 wt%) having 100 In wires (1 mm $\Phi \times$ 10 mm) thereon was installed in the second vacuum chamber. A mask was placed on the multilayer stack formed in the first vacuum chamber, and sputtering was performed to form a 7 nm-thick electron-injecting electrode layer.
Subsequently, the substrate was transferred to a substrate holder in a third vacuum chamber which was connected to the second vacuum chamber. During this transfer, the degree of vacuum was kept unchanged. The third vacuum chamber also had a configuration which allows an oxide conductive film to be formed by DC magnetron sputtering. In the third vacuum chamber, an IZO target ($In_2O_3$:ZnO=89.3:10.7 wt%) was installed. A mixed gas of an argon gas and an oxygen gas (1000:2.8 in volume ratio) was introduced to $3 \times 10^{-1}$ Pa. A transparent conductive film with a thickness of 200 nm was formed on the following conditions, thereby fabricating an organic EL device shown in FIG. 2.
Sputtering output: 20 W
Substrate temperature: Room temperature

(3) Evaluation of organic EL device

The ITO thin film and the IZO film of the organic EL device were used as an anode and a cathode, respectively. A voltage of 8V was applied to this device. The current density was 5.1 $mA/cm^2$, and the luminance, which was observed from above the IZO electrode film, was 80 $cd/m^2$. The emission was green emission generataed from Alq. The current density (J) was measured by means of Model 6487 of Keithley Instruments, Inc. The luminance (L) was measured by means of BM-9 of TOPCON Corporation.

Example 2

(1) Formation of conductive composition film

A 4-inch ITO target ($In_2O3$:SnO=90:10 wt%, manufactured by Furuuchi Chemical Corporation) was installed in a sputtering apparatus. 100 Sn wires ($\Phi$ 1 mm $\times$ 10 mm) were placed on the target. After degassing to $2 \times 10^{-4}$ Pa, sputtering was performed to form a film on glass on the following conditions:

Sputtering pressure: 0.1 Pa
Sputtering gas: argon (100%)
Sputtering output: 0.1 $W/cm^2$
Sputtering time: 30 seconds
The resulting conductive film had a thickness of 10 nm and a specific resistance of $1.2 \times 10^{-3}$ $\Omega \cdot cm$. The work function of the IZO film was measured by means of AC-1 (manufactured by Riken Keiki Co., Ltd.), and found to be 4.1 eV. The light transmittance was 60%. The element ratio of In, Sn and O was measured by means of an SIMS. In:Sn:O was 55:15:30 (at%).

(2) Preparation of organic EL device

An organic EL device was obtained in the same manner as in Example 1, except that an electron-injecting electrode layer composed of the conductive composition film prepared in above (1) was formed in the second vacuum chamber using an ITO target having 100 Sn wires thereon.

(3) Evaluation of organic EL device

The ITO thin film and the IZO film were used as an anode and a cathode, respectively. A voltage of 8V was applied to this device. The current density was 5.0 $mA/cm^2$, and the luminance, which was observed from above the IZO electrode film, was 77 $cd/m^2$. The emission was green emission generated from Alq.

Examples 3 to 13

Conductive composition films were prepared in the same manner as in Example 1 or 2, except that the target and the wire shown in Table 1 were used. Organic EL devices were prepared and evaluated in the same manner as in Example 1 or 2, except that electron-injecting electrode layers composed of these conductive composition films were formed. The IO target in Example 13 was a target composed of indium oxide.
The light transmittance and the work function of the conductive composition films, and the current density and the luminance of the organic EL devices were measured and the results are shown in Table 1.
Table 1

| | Target | Wire | Element ratio(at%) | Transmittance (%) | Work function (eV) | Current density (mA/cm$^2$) | Luminance (cd/m$^2$) |
|---|---|---|---|---|---|---|---|
| Example 1 | IZO | In × 100 | In:Zn: O=50:10: 35 | 80 | 4.2 | 5.1 | 80 |
| Example 2 | ITO | Sn × 100 | In:Sn: O=55:15: 30 | 60 | 4.1 | 5.0 | 77 |
| Example 3 | ITO | V × 100 | In:Sn:V: O=50:15: 10:25 | 65 | 4.3 | 4.9 | 75 |
| Example 4 | IZO | W × 100 | In:Zn:W: O=50:15:9: 26 | 66 | 4.2 | 5.2 | 75 |
| Example 5 | ITO | Ni × 100 | In:Sn:Ni: O=50:15: 13:22 | 65 | 4.1 | 5.2 | 81 |
| Example 6 | ITO | Pd × 100 | In:Sn:Pd: O=49:14: 12:25 | 70 | 4.2 | 5.2 | 79 |
| Example 7 | IZO | Pt × 100 | In:Zn:Pt: O=50:14: 12:24 | 75 | 4.3 | 5.0 | 76 |
| Example 8 | IZO | Cu × 100 | In:Zn:Cu: O=50:14: 12:24 | 60 | 4.3 | 5.0 | 75 |
| Example 9 | IZO | Ag × 100 | In:Zn:Ag: O=50:14: 12:24 | 65 | 4.2 | 5.2 | 76 |
| Example 10 | IZO | Au × 100 | In:Zn:Au: O=50:14: 12:24 | 60 | 4.3 | 5.0 | 76 |
| Example 11 | ITO | In × 160 | In:Sn: O=70:9:21 | 55 | 4.3 | 4.8 | 65 |
| Example 12 | IZO | In × 10 | In:Zn: O=33:9:58 | 85 | 4.2 | 4.3 | 60 |
| Example 13 | IO | In × 100 | In:O=65:35 | 75 | 4.2 | 5.2 | 69 |
| Com. Ex. 1 | IZO | None | In:Zn: O=27:8:65 | 88 | 4.5 | 3.5 | 20 |
| Com. Ex. 2 | IZO | In × 5 | In:Zn: O=29:8:67 | 87 | 4.6 | 3.8 | 25 |
| Com. Ex. 3 | IZO | Zn × 180 | In:Zn:O=5: 80:15 | 15 | 4.2 | 4.2 | 16 |

Comparative Example 1

A conductive composition film was prepared in the same manner as in Example 1, except that the In wires were not used. An organic EL device was prepared and evaluated in the same manner as in Example 1, except that an electron-injecting electrode layer composed of this conductive composition film was formed. The results are shown in Table 1.

Comparative Example 2

A conductive composition film was prepared in the same manner as in Example 1, except that the number of In wires was changed to 5. An organic EL device was prepared and evaluated in the same manner as in Example 1, except that an electron-injecting electrode layer composed of this conductive composition film was formed. The results are shown in Table 1.

Comparative Example 3

A conductive composition film was prepared in the same manner as in Example 1, except that the number of Zn wires was changed to 180. An organic EL device was prepared and evaluated in same manner as in Example 1, except that an electron-injecting electrode layer composed of this conductive composition film was formed. The results are shown in Table 1.

INDUSTRIAL APPLICABILITY

Due to the small work function and the high transparency, the conductive composition film of the invention can be used preferably as an electron-injecting electrode in fields where transparency is required. Specifically, the conductive composition film of the invention is suitable as a transparent conductive film for various displays such as organic EL displays and liquid crystal displays.

**Claims**

1. A conductive composition film comprising the following elements A and B, and an oxygen atom:

    A: one element selected from In, Sn, and Zn; and
    B: one or more elements selected from In, Sn, Zn, V, W, Ni, Pd, Pt, Cu, Ag and Au and different from element A; the total $(x+y)$ of the amount $(x)$ of element A and the amount $(y)$ of element B in the film being larger than 41 at% and smaller than 80 at%; and
    the amount of the oxygen atom in the film being $[100-(x+y)]$ at%.

2. A conductive composition film comprising at least one metal element selected from In, Sn and Zn, and an oxygen atom; the amount $(x)$ of the metal element in the film being larger than 41 at% and smaller than 80 at%; and the amount of the oxygen atom in the film being $(100-x)$ at%.

3. A conductive composition film comprising one metal element selected from In, Sn and Zn, and an oxygen atom; the amount $(x)$ of the metal element in the film being larger than 41 at% and smaller than 80 at%; and the amount of the oxygen atom in the film being $(100-x)$ at%.

4. An electron-injecting electrode which comprises the conductive composition film according to any one of claims 1 to 3.

5. The electron-injecting electrode according to claim 4, which has a light transmittance in the visible range of 20% or more.

6. An organic EL device comprising an anode, a cathode, and, interposed therebetween, an organic layer including an organic emitting layer; the cathode being the electron-injecting electrode according to claim 4 or 5.

7. The organic EL device according to claim 6, wherein the anode is light reflective and emission is outcoupled from the cathode side.

FIG. 1

Light

1

14

13
12
11

FIG. 2

Light

2

14-2
14-1  } 14'

13
12
11

FIG. 3

Light

3

14
15

L

13
12
11

## INTERNATIONAL SEARCH REPORT

| | International application No. |
|---|---|
| | PCT/JP2006/316050 |

**A. CLASSIFICATION OF SUBJECT MATTER**
*H01B1/08*(2006.01)i, *H01L51/50*(2006.01)i, *H05B33/28*(2006.01)i

According to International Patent Classification (IPC) or to both national classification and IPC

**B. FIELDS SEARCHED**

Minimum documentation searched (classification system followed by classification symbols)
H01B1/08, H01B5/14, H01L51/50, H05B33/28

Documentation searched other than minimum documentation to the extent that such documents are included in the fields searched

| Jitsuyo Shinan Koho | 1922-1996 | Jitsuyo Shinan Toroku Koho | 1996-2006 |
|---|---|---|---|
| Kokai Jitsuyo Shinan Koho | 1971-2006 | Toroku Jitsuyo Shinan Koho | 1994-2006 |

Electronic data base consulted during the international search (name of data base and, where practicable, search terms used)
JSTPlus(JDream2)

**C. DOCUMENTS CONSIDERED TO BE RELEVANT**

| Category* | Citation of document, with indication, where appropriate, of the relevant passages | Relevant to claim No. |
|---|---|---|
| X<br>Y | US 2001/0008710 A1 (TAKATSUJI et al.),<br>19 July, 2001 (19.07.01),<br>Claims<br>& JP 2000-67657 A | 1-2<br>4-7 |
| X | US 6628086 B2 (Hayashi et al.),<br>30 September, 2003 (30.09.03),<br>Claims<br>& JP 2002-252088 A | 1-2 |
| X<br>Y | JP 57-6761 B2 (Sharp Corp.),<br>06 February, 1982 (06.02.82),<br>Full text; Figs. 1 to 2<br>(Family: none) | 3<br>4-7 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 November, 2006 (13.11.06) | 21 November, 2006 (21.11.06) |

| Name and mailing address of the ISA/<br>Japanese Patent Office | Authorized officer |
|---|---|
| Facsimile No. | Telephone No. |

Form PCT/ISA/210 (second sheet) (April 2005)

**INTERNATIONAL SEARCH REPORT**

| International application No. |
|---|
| PCT/JP2006/316050 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2002-359086 A  (Toyota Central Research And Development Laboratories, Inc.), 13 December, 2002 (13.12.02), Claims; Par. Nos. [0015] to [0017]; Fig. 1 (Family: none) | 4-7 |
| Y | JP 2001-43980 A  (Sony Corp.), 16 February, 2001 (16.02.01), Par. Nos. [0014] to [0015]; Fig. 1 & US 2003/0171060 A1 | 7 |
| A | EP 1041644 A2  (Rockwell Science Center, LLC), 04 October, 2000 (04.10.00), & JP 2001-7026 A        & US 2002/0084455 A1 | 1-7 |
| A | W.Osikowicz et al., "Transparent low-work-function indium tin oxide electrode obtained by molecular scale interface engineering", Appl.Phys.Lett., Vol.85, No.9, 2004.08.30, p.1616-1618 | 1-7 |

Form PCT/ISA/210 (continuation of second sheet) (April 2005)

## EP 1 921 633 A1

### REFERENCES CITED IN THE DESCRIPTION

**Patent documents cited in the description**

- JP 2001043980 A

- JP 2004030934 A